# EUROPEAN PATENT APPLICATION

(11) **EP 2 887 779 A1**
(43) Date of publication of application: **24.06.2015**
(21) Application number: 13198900.6
(22) Date of filing: 20.12.2013
(51) Int. Cl.: H05K 3/24, H01L 23/00

(54) **Silver wire bonding on printed circuit boards and IC-substrates**

(71) Applicant: Atotech Deutschland GmbH, 10553 Berlin (DE)
(72) Inventor: Özkök, Mustafa, 13591 Berlin (DE); Ramos, Gustavo, 10117 Berlin (DE)
(74) Representative: Wonnemann, Jörg

(57) **Abstract**

The present invention relates to a method of bonding a silver based wire to a substrate, particularly a printed circuit board and an IC-substrate, possessing a layer assembly comprising a copper bonding portion and a palladium or palladium alloy layer and a substrate having a silver wire bonded to aforementioned layer assembly.

## Description

### Description of the invention

The present invention relates to a method of bonding a silver based wire to a substrate, particularly a printed circuit board and an IC-substrate, possessing a layer assembly comprising a copper bonding portion and a palladium or palladium alloy layer, optionally a gold or gold alloy layer and a substrate having a silver based wire bonded to aforementioned layer assembly.

### Background art

In printed circuit board (PCB) and integrated circuit (IC) substrate manufacturing it is required that electronic components are bonded to selected bonding areas (bond pads as the bonding portion) of a copper structure produced on one or on both sides of the substrate. Such interconnection must be reliable in terms of bond strength, i.e., thermal stress imposed on a bonding interconnection must by no means result in a break of this interconnection.

Wire bonding is one of the preferred processes for connecting the chip to the IC-substrate in IC packages and it accounts for more than 70% of the commercial IC production. Currently, the main wire bonding process used for IC-substrate is gold wire bonding, wherein a gold wire is bonded on a layer of electrolytically deposited nickel and gold. Alternatively, the gold wire is bonded onto a surface of nickel, palladium and gold. In all cases, the copper wire is bonded onto the final gold layer.

Silver wire bonding has recently been introduced as an alternative to gold wire bonding because silver has the highest electrical conductivity of all metals and it is not easily oxidized at room temperature. Furthermore, it is soft and malleable which enables stable ultrasonic welding to chips using a standard process known as wire-bonding, without the potential for damage to chips.

The mechanical reliability of wire bonds in microelectronic package depends to a big extent on the formation and development of intermetallic compounds at the interface between the bond wedge and the bond pad on the substrate (printed circuit board, PCB or IC-substrate), which is crucial for successful bonding.

Wire bonding portions are typically made of copper. If they remain bare or are externally exposed to atmosphere and humidity, soldering and wire bonding properties of the copper layers deteriorate due to oxidation or corrosion of the surface. In order to maintain soldering or wire bonding properties, therefore, the bare or exposed copper layers are usually electroplated or plated electrolessly with nickel. The plated nickel layer protects the copper from an erosive atmosphere for a long period of time. Also, the nickel layer protects the copper from being dissolved by solder during the soldering assembly step by functioning as a diffusion barrier layer. In addition, the plated nickel layer plays a role as an interfacial film for preventing the copper layer and the gold layer, to be plated later, from diffusing into each other. Thereafter, wire bonding gold is plated to a thickness of around 0.5 µm in an electrolytic or electroless manner, so as to impart properties facilitating a wire bonding process. Such processes are for example described in US 5,235,139 and US 6,733,823.

US 2007/0104929 relates to a method for plating a printed circuit board, comprising the steps of: (a) providing a printed circuit board with predetermined circuit patterns, having a wire bonding portion for surface mounting semiconductors thereon and a soldering portion for connecting external parts with the printed circuit board; (b) forming a photo solder resist layer to the remaining portions exclusive of the wire bonding portion and the soldering portion in the printed circuit board; (c) forming an electroless palladium or palladium alloy plated layer on the wire bonding portion and the soldering portion; and (d) immersing the palladium or palladium alloy plated layer with a substitution type immersion gold plating solution containing a water-soluble gold compound to form an electroless gold or gold alloy plated layer on the palladium or palladium alloy plated layer.

US 2006/055023 concerns a chip carrier comprising a laminated layer and an oxidation protection layer. The oxidation protection layer is a non-electrolytic metallic coating or an organic oxidation protection film on the surface of bonding finger pads or other contacts formed by deploying a simple, fast film-coating technique.

US 5,175,609 relates to new structures and methods for corrosion- and stress-resistant interconnecting multilayer metallurgical pads comprising sequentially deposited layers of chromium, nickel and noble or relatively noble metal as the interconnecting metallurgy, or multilayer metallurgical pads comprising sequentially deposited layers of chromium, soluble noble metal, nickel and noble or relatively noble metal as the interconnecting metallurgy.

EP 0 697 805 A1 relates to a way of manufacturing printed circuit boards by providing a circuit board with a circuit pattern, holes and lands of copper; covering the circuit pattern with a solder mask; and contacting the board with an electroless palladium solution for a sufficient time to provide a final finish layer of palladium at a sufficient thickness to protect the copper deposits in the holes and on the lands from oxide formation and being relatively smooth and flat to provide good solderability and good wire bonding capabilities. The copper circuit pattern, holes and lands is generally provided by plating copper onto the board. Then, the palladium layer may be provided directly onto the copper or onto a layer of electroless nickel which is initially deposited upon the copper. US 2012/0186852 discloses a layer array consisting of palladium and gold while omitting the nickel layer for bonding copper based wires.

### Summary of the invention

It is an object of the present invention to provide a layer sequence to be deposited on a substrate bearing a wire bonding portion made of copper that ensures good reliability of wire bonds to be formed and does not contain a nickel layer plated on the bonding portion made of copper.

It is another object of the present invention to provide a method of forming said layer while allowing for stable wire bonds, more specifically silver based wire bonds to be formed on such metal layer.

It is still another object of the present invention to provide an IC-substrate, said IC-substrate having a copper structure, wherein the copper structure is coated with a metal layer sequence comprising at least one layer of palladium and, optionally, a layer of gold.

It is still another object of the present invention to provide a printed circuit board, said printed circuit board having a copper structure, wherein the copper structure is coated with the metal layer.

To achieve these objects, the present invention provides a metal layer assembly, comprising forming a silver based wire on a substrate, said substrate having at least one wire bonding portion made of copper or copper alloy comprising the steps of
(i) providing a substrate having at least one wire bonding portion made of copper or copper alloy;
(ii) forming a palladium or palladium alloy layer on the at least one wire bonding portion, wherein the palladium is deposited from a wet chemical plating bath;
   optionally, (ii) a) forming a gold or gold alloy layer on the palladium or palladium alloy layer, wherein the gold or gold alloy layer is deposited from a wet chemical plating bath;
(iii) bonding a silver based wire onto the palladium or palladium alloy layer.

The steps are performed in the aforementioned order.

The palladium or palladium alloy layer as deposited in step (ii) has a thickness of 0.01 - 5.0 µm, preferably 0.05 - 2.0 µm and even more preferred 0.1 - 0.5 µm.
In a preferred embodiment of the method, the palladium layer consists of pure palladium. In another preferred embodiment the layer assembly does not contain any nickel or nickel alloy layers on the wire bonding portion but only a palladium or palladium alloy layer plated directly onto the wire bonding portion.

The palladium is preferably deposited from an electroless (autocatalytic) plating palladium bath comprising
■ a palladium ion source;
■ a complexing agent;
■ a reducing agent.

Hitherto, it was common to plate a nickel or nickel alloy layer onto the wire bonding portion layer made of copper or copper alloy. Such nickel layer generally had a thickness of 0.5 - 10.0 µm.

This is no longer required in the process according to the present invention. In a preferred embodiment of the present invention no nickel layer is deposited on the bonding portion made of copper or copper alloy. It is therefore preferential that the palladium or a palladium alloy layer is formed directly on the copper or copper alloy bonding portion. Preferably, no nickel or other metal layer is formed between the copper or copper alloy bonding portion and the palladium or palladium alloy layer. The copper or copper alloy wire bonding portion, however, might be activated prior to the deposition of a palladium or palladium alloy layer. Such activation can include treatment in a solution containing metal ions, e.g. palladium ions.

The inventors have found that it is particularly advantageous to apply a pure palladium layer onto the copper or copper alloy of the wire bonding portion. Pure palladium is even more preferred according to an embodiment wherein no nickel or nickel alloy layer is deposited on the wire bonding portion made of copper or copper alloy prior to palladium or palladium layer plating. A pure palladium layer according to the present invention is a layer comprising a palladium content of more than 99.0 wt.-%, preferred more than 99.5 wt.-% palladium or more preferred more than 99.9 wt.-% or even more preferred more than 99.99 wt.-% palladium.

In another embodiment of the method, the palladium plated layer is an alloy layer which comprises 90.0 to 99.9 wt.-% of palladium, and 0.1 to 10.0 wt.-% of phosphorus or boron.

In a preferred embodiment of the present invention the metal layer only comprises one layer being a palladium or palladium alloy like palladium-phosphorus or palladium-boron layers, which is directly formed on the copper or copper alloy wire bonding portion of the substrate.

Generally, the copper or copper alloy surface of the bonding portion is prepared for plating by prior treatment with an acid cleaner and then the surface copper oxides are reduced in a micro-etch bath.

For the purpose of the present invention it can be useful to apply an additional activation step to the copper or copper alloy wire bonding portion prior to depositing the palladium or palladium alloy layer. Such activation solution can comprise a palladium salt which results in a thin palladium layer. Such layer is very thin and usually does not cover the entire copper or copper alloy wire bonding portion. It is not considered a distinct layer of the layer assembly but rather an activation, which forms a metal seed layer in addition to the palladium / palladium alloy layer. Such seed layer is plated to the copper or copper alloy layer by an immersion exchange process.

Such activation solution is particularly preferred if the deposition of the palladium layer is by an electroless (autocatalytic) plating method.

This palladium or palladium alloy layer is preferably plated onto the copper or copper alloy structure, which is provided on an IC-substrate or printed circuit board.
An IC-substrate comprises a carrier corpus and the copper structure, which is provided on one or both sides of said carrier corpus. Hence, the metal structure is coated with the palladium or palladium alloy layer. Thereafter, a silver based wire is bonded onto the palladium or palladium alloy layer.

The copper structure comprises a wire bonding portion (also called bond pads), which serves as connection of electronic components to the substrate, conductor lines, which serve as electrical connection between pads and between metalized holes and pads, and other conductor areas, like ground areas, shielding areas and the like. The palladium or palladium alloy layer is preferably coated to the solder and bonding portion only, but not on the conductor lines and the other conductor areas.

In contrast to the prior art, the layer assembly of the present invention provides for most reliable bond connections between an electronic component and the substrate.

The method of the invention preferably comprises depositing of the palladium or palladium alloy layer by electroless (autocatalytic) plating. Electroless (autocatalytic) plating involves depositing the metal by reducing the same with the help of a chemical reducing agent which is contained in the electroless plating solution, this chemical reducing agent being oxidized thereupon.

Further, the pure palladium layer may preferably be deposited by bringing the at least one copper wire portion of the substrate into contact with a solution containing a palladium ion source and a reducing agent, which preferably does not contain phosphorous and results in a deposition of a pure palladium layer.

A suitable electroless (autocatalytic) plating bath composition to deposit layers of pure palladium is for example described in US 5,882,736. Such plating bath contains a palladium salt, one or more nitrogenated complexing agents, and formic acid or formic acid derivatives, but neither hypophosphite nor amine borane compounds. The pH value of the solution is above 4. Preferably, primary, secondary or tertiary amines or polyamines are used as the nitrogenated complexing agents. They are, for example, ethylene-diamine; 1,3-diamino-propane, 1,2-bis (3-amino-propyl-amino)-ethane; 2-diethyl-amino-ethyl-amine; and diethylene-triamine. In addition, diethylene-triamine-tri-acetic acid; N-(2-hydroxy-ethyl)-ethylene-diamine; ethylene-diamine-N,N-diacetic acid; 2-(dimethyl-amino)-ethyl-amine; 1,2-diamino-propyl-amine; 1,3-diamino-propyl-amine; 3-(methyl-amino)-propyl-amine; 3-(dimethyl-amino)-propyl-amine; 3-(ethyl-amino)-propyl-amine; 3-(diethyl-amino)-propyl-amine; bis (3-amino-propyl)-amine; 1,2-bis (3-amino-propyl)-alkyl-amine; diethylene-triamine; triethylene-tetramine; tetra-ethylene-pentamine; penta-ethylene-hexamine; and any desired mixtures of these nitrogenated complexing agents may also be used. However, sulfur containing compounds are not used as stabilizers together with the complexing agents.

More preferably, the solution used to deposit the pure palladium layer in an electroless manner is aqueous and contains a palladium salt, such as palladium chloride or palladium sulfate, a non-hypophosphite containing compound as a reducing agent like formic acid, mineral acids, such as sulfuric acid or hydrochloric acid, or mineral bases, like sodium or potassium hydroxide, complexing agents, like amine compounds, such as ethylene diamine, and, if necessary, stabilizing compounds. Alternatively, other electroless palladium deposition solutions and processes may be used which are well-known in the art and which are described in: US Patent Nos. 5,292,361, 4,424,241, 4,341,846, 4,279,951 and 4,255,194.

The layer assembly of the present invention may also contain a gold or gold alloy layer plated onto the palladium or palladium alloy layer. This gold or gold alloy layer is deposited on the latter by a wet-chemical process. Preferably, this wet chemical gold or gold alloy plating bath is an immersion plating bath comprising a gold ion source and a complexing agent. The such deposited gold or gold alloy layer preferably has a thickness of 0.05 - 3.0 µm, even more preferably between 0.1 and 0.5 µm.

In a further preferred embodiment of the invention, one or both sides of the substrate is/are provided with a conformal mask, said conformal mask covering all regions on said one or both sides of said substrate except those regions on said one or both sides where the palladium or palladium alloy layer is to be coated on the at least one copper wire portion. The conformal mask may preferably be a solder mask, like an exposable and developable mask. Such mask can be based on epoxy resin for example and is laminated, spin-coated, roller-coated or the like to the surface(s) of the circuit carrier. Thereafter it is exposed to actinic light and developed to uncover those regions on the surface(s) where the layer assembly is to be deposited. It is these regions where the wire bonding portions are to be provided. The conformal mask may be formed such that the uncovered regions on the surface(s) of the substrate are larger than the wire bonding portions formed in the copper structure, thereby exposing parts of dielectric surface regions of the substrate, or smaller than the wire bonding portions formed in the copper structure, such that only the wire bonding portions formed on the copper structure are uncovered.

### Detailed description of the invention

According to the process of the present invention an exposed wire bonding portion made of copper or copper alloy is plated with a pure palladium or a palladium alloy layer.

The palladium alloy layer preferably is a palladium-phosphorous layer having a phosphorous content of 0.1 - 10.0 wt.-%, more preferred 0.5 - 7.0 wt.-% or a palladium-boron layer having a boron content of 0.1 - 10.0 wt.-%, more preferred 0.5 - 7.0 wt.-%. A pure palladium layer according to the present invention is a layer comprising a palladium content of more than 99.0 wt.-%, preferred more than 99.5 wt.-% palladium or more preferred more than 99.9 wt.-% or even more preferred more than 99.99 wt.-% palladium. A pure palladium layer is preferred.

On the exposed wire bonding portions palladium or palladium alloy is plated to form a palladium or palladium alloy plated layer. Below, a more detailed description is given of the formation of the electroless palladium or palladium alloy plated layer on the wire bonding portion.

The reducing agent employed in the plating solution determines whether pure palladium or a palladium alloy (palladium-phosphorus, palladium-boron) is plated. For example, a typical electroless palladium plating solution useful in the present invention comprises palladium sulfate as a palladium source, sodium hypophosphite or dimethyl amine borane, formaldehyde or formic acid as a reducing agent, lactic acid as a complexing agent, and succinic acid as a buffer, but is not limited thereto.

In order to obtain a denser structure of the palladium plated layer, the pH of the electroless palladium plating solution preferably falls in the range from 4.5 to 5.5.

The palladium or palladium alloy plating process is conducted at about 45 to 80 °C for 1 to 60 min to give a palladium or palladium alloy plated layer ranging in thickness from 0.01 to 5.0 µm, more preferred from 0.05 to 2.0 µm and even more preferred 0.1 to 0.5 µm.

The concentration of the complexing agents in the bath depends on the palladium content. Typically, the mole ratios of the complexing agents to the palladium are from 5:1 to 50:1, whereby the concentration of the complexing agents in the bath is 0.05 g/I to 100 g/I of bath.

The pH-value of the coating solution is generally greater than 4. At pH-values below 4, the solution becomes unstable and tends to self-decompose as hydrogen is being produced. At pH-values slightly below 4, mainly poorly adhesive and dark palladium layers are deposited on the metal surfaces; while at pH-values lower than about 2 palladium precipitates out of the solution. In this case, the precipitates obtained on the substrate are black and inadequately adhesive.

The preferred pH-value of the coating solution is in the range from 5 to 6. At pH-values greater than 7, the tendency of the alkaline bath to deposit palladium on the metal surfaces in a cementative fashion increases, i.e. neither brightly glossy nor adhering to the substrate. Furthermore, alkaline coating solutions would attack the organic resistance films such as, for example, the solder stop masks, applied to the circuit board.

If the pure palladium layer is directly to be deposited on the copper or copper alloy layer of the wire bonding portion a pretreatment of the copper surface is advisable. For this purpose, etch cleaning is usually carried out in acidic oxidizing solutions, for example a solution of sulfuric acid and hydrogen peroxide. Preferably, this is followed by another cleaning in an acidic solution, such as, for example, a sulfuric acid solution. After cleaning, the surfaces are preferably activated with a solution containing palladium such as, for example, a palladium sulfate solution, which contains additional acids like sulfuric acid, methane sulfonic acid and phosphoric acid. Typically, the substrates are immersed in the activation bath at 25 to 30 °C for one to four minutes.

This activation step is preferred for the following reason: In the subsequent deposition step, e.g. in an electroless (autocatalytic) palladium bath, the bath contains a reducing agent that is catalytically activated by the presence of palladium metal. Therefore, at least some palladium has to be deposited on the copper surface by an immersion process, in which the more noble metal palladium displaces the less noble copper. This initial immersive palladium deposition may take place also if the copper surface is immersed directly into an autocatalytic palladium bath, and once a minute amount of palladium has been deposited, the process proceeds as an autocatalytic deposition. Autocatalytic palladium bath compositions were found to be deactivated by an excess of copper ions. If the initial immersive palladium deposition is performed in the autocatalytic palladium bath, inevitably, enrichment with copper ions occurs. Therefore, in a production environment it can be preferable to apply an immersion palladium bath (see above for a description of the activation solution) in an extra step before the autocatalytic palladium bath to prolong the lifetime of the latter.

After this, in a preferred embodiment, the surfaces can be rinsed and then, after pretreatment in the activation palladium bath described above, be treated with an electroless (autocatalytic) palladium bath described above; in another case, they can be immediately treated with the electroless (autocatalytic) palladium bath without pretreatment in the activation palladium bath. Further rinsing steps, preferably with water as rinsing agent, may be incorporated in the described process step sequence before, between or after any of the described process steps.

The optional gold layer is most preferably deposited by an immersion process. Immersion-type plating is an established method to deposit a layer of gold onto a metal substrate. Gold ions present in such plating bath compositions are reduced to metallic gold when in contact with a metal present on the substrate surface which is less noble than gold. Thereby, the metal from the substrate surface is oxidized to its cationic form and transferred to the gold plating bath. Such plating bath compositions do not contain a strong reducing agent such as hypophosphite ions or formaldehyde which is common in plating baths for electroless deposition of e.g., nickel alloys and copper.

The aqueous immersion-type plating bath according to the present invention comprises gold ions in either Au⁺, Au³⁺ or both oxidation states. The source of gold ions is a water soluble salt such as trisodium gold disulfite, tripotassium gold disulfite and triammonium gold disulfite, gold thiosulfate, gold thiocyanide, gold sulfate, gold chloride, potassium gold dicyanide and gold bromide. Preferably, the source of gold ions is added to the aqueous plating bath in the form of a gold sulfite solution. The concentration of gold ions in the aqueous plating bath preferably ranges from 0.1 to 10 g/I, more preferably from 0.3 to 6 g/I.

The at least one complexing agent present in the aqueous plating bath is preferably selected from the group comprising carboxylic acids, hydroxycarboxylic acids, aminocarboxylic acids or a salt of the aforementioned and serves as a complexing agent for gold ions as well as for metal ions dissolved from the substrate during plating, e.g., palladium ions. A preferred carboxylic acid is for example oxalic acid or a salt thereof. Preferred hydroxycarboxylic acids are for example tartaric acid, citric acid, lactic acid, malic acid, gluconic acid and salts of the aforementioned. Preferred aminocarboxylic acids are for example glycine, cysteine, methionine and salts of the aforementioned. In all cases the sodium, potassium and ammonium salts of said compounds are also suitable. The concentration of the at least one complexing agent preferably ranges from 0.1 to 25.0 g/I, more preferably from 0.5 to 10.0 g/I.

The temperature of the aqueous plating bath is preferably in the range from 30 to 70 °C, more preferably from 40 to 60 °C during plating. The plating time is preferably in the range from 40 to 60 min, more preferably in the range from 5 to 30 min. The optional gold or gold alloy layer to be deposited on the palladium layer has a thickness of 0.05 to 3.0 µm, preferably 0.1 to 0.5 µm.

The immersion-type plating bath according to the present invention may be used with horizontal, vertical and spray plating equipment.

Alternatively, an electroless process to deposit the optional gold layer is also within the scope of the present invention. A typical bath for this process comprises at least a gold compound, a complexing agent such as sulfites, thiosulfites, aminocarboxylic acids or organophosphonic acids, a reducing agent such as formaldehyde, sodium sulfite or thiourea and a solvent such as water. Furthermore, the bath might encompass further components like acids, bases or stabilizers such as nitrogen or sulfur-containing compounds. These processes are well-known in the art and have been disclosed, e.g. in German patent DE 197 45 601 or US patent applications no. 2008/0277140 or 2008/0138507. A combination of both immersion-type and electroless deposition might occur depending on the exact plating bath chosen and lies therefore within the scope of the present invention.

Prior to bonding of the wire onto the bonding site an optional cleaning of this surface by either chemical or physical methods such as plasma processes is advisable. As chemical cleaning processes acidic and / or alkaline treatments are commonly used.

The silver based wire can be
■ a silver wire or;
■ a silver alloy wire or;
■ a silver wire, which is coated with a gold, palladium, platinum or rhodium layer or;
■ a silver alloy wire, which is coated with a gold, palladium, platinum or rhodium layer.

Typical silver alloy wires contain palladium or copper as alloying materials. If the alloying material is copper, the copper content generally ranges between 0.1 and 20 wt.-%, preferably between 0.5 and 5 wt.-%, the rest being silver. If the alloying material is palladium, the palladium content generally ranges between 0.1 and 20 wt.-%, preferably between 1 and 5 wt.-%, the rest being silver.

The silver or silver alloy wire may be coated with any suitable coating material. Preferably, this coating material is a noble metal. Typical noble metals are gold, palladium, platinum and rhodium. The thickness of the coating generally ranges between 1 and 500 nm, preferably between 5 and 50 nm. The manufacture of such coated bonding wires is known in the art and for example disclosed in WO 2013/076548 A1.

The diameter of the bonding wire of the present invention is not specifically limited, but when an object is to form a small diameter ball, a wire diameter of between 10 to 100 µm is preferable. Even more preferred is a diameter of between 15 to 40 µm.

A typical layer assembly obtained by a method according to the present invention comprises
(i) at least one wire bonding portion made of copper or copper alloy; and directly deposited thereon
(ii) a palladium or palladium alloy layer, preferably having a thickness of 0.01 - 5.0 µm, preferably having a thickness of 0.05 - 2.0 µm and even more preferably of 0.1 - 0.5 µm; and
(ii) a) optionally, a gold or gold alloy layer having a thickness of 0.05 - 3.0 µm, more preferably having a thickness of 0.1 - 0.05 µm; and
(iii) a silver based wire bonded onto the deposited metal layer or layers.

A printed circuit board possessing a layer assembly as described above and, additionally, a soldering portion for connecting external parts with the printed circuit board is a typical substrate which can be obtained by a method according to the present invention. The inventive layer assembly and the silver or silver alloy wire can also be used on microchips.

Wire bonding site and bonding site are used interchangeably in the context of the present invention. The following examples serve to illustrate various aspects of the present invention.

### Examples

A single sided printed circuit board (PCB, array size 61.8 mm x 113.8 mm) was used as substrate. The array consisted of two single cards (50 mm x 50 mm). The total thickness of the copper layer on the substrate was 30 µm (+/- 5 µm). The wire bonding itself was not performed on any specific area of said substrate. The base material of the PCB used in the experiments described herein was Hitachi MCL-E679FGB-(S), FR4 18/80, 300 µm.

### General procedure for the plating process

The individual plating sequences on the substrate are shown in the tables below. Samples 1 and 3 (see table 1) are palladium coated substrates, samples 2, 4 and 5 (cf. table 2) bear an layer assembly of palladium and gold layers on the substrate.

**Table 1: Plating of pure palladium onto the silver wire bonding portion (according to the present invention, samples 1 and 3)**

| **Process Step** | | **Substance** | **Temperature [°C]** | **Process Time [min]** |
|---|---|---|---|---|
| 1 | Cleaner | Cleaner SF | 40 | 5 |
| 2 | Rinse | DI Water | 20 | 2 |
| 3 | Micro Etch | Micro Etch | 35 | 2 |
| 4 | Rinse | DI Water | 20 | 2 |
| 5 | Pre-Dip | Pre-Dip Pd Activator | 20 | 3 |
| 6 | Activation | Pd-Activator | 20 | 2 |
| 7 | Rinse | DI Water | 20 | 2 |
| 8 | Electroless Pd | Electroless Pd | 50 | 10 |
| 9 | Rinse | DI Water | 20 | 2 |
| 10 | Hot rinse | DI Water | 50 | 1 |
| 11 | Drying | - | 60 | 15 |

**Table 2: Plating of pure palladium and gold onto the silver wire bonding portion (according to the present invention, samples 2, 4 and 5)**

| **Process Step** | | **Substance** | **Temperature [°C]** | **Process Time [min]** |
|---|---|---|---|---|
| 1 | Cleaner | Cleaner SF | 40 | 5 |
| 2 | Rinse | DI Water | 20 | 2 |
| 3 | Micro Etch | Micro Etch | 35 | 2 |
| 4 | Rinse | DI Water | 20 | 2 |
| 5 | Electroless Pd | Electroless Pd | 50 | 10 |
| 6 | Rinse | DI Water | 20 | 2 |
| 7 | Immersion Au | Immersion Au | 82 | 10 |
| 8 | Hot rinse | DI Water | 50 | 1 |
| 9 | Drying | - | 60 | 15 |

Materials used in the plating experiments according to Tables 1 and 2:

| | |
|---|---|
| Cleaner | Cleaner SF (Atotech Deutschland GmbH) |
| | 25 g/l organo sulfonic acid, 10 g/I glycol ether |
| Micro Etch | Micro Etch (Atotech Deutschland GmbH) |
| | 500 g/l potassium caroate |
| Pre-Dip Pd-Activator | 50 g/l Phosphoric Acid (85%), 11 g/l Sodium Nitrate |
| Pd-Activator | 50 g/l Phosphoric Acid 85% |
| | 10 g/l Methane Sulfonic Acid 70% |
| | 0.15 g/l Palladium Sulfate |
| Electroless Pd | 30 g/l ethylenediamine |
| | 400 g/l reducing agent |
| | 1 g/l Pd(II) ions from palladium sulfate |
| Immersion Au | 30 g/l EDTA |
| | 30 g/l hydroxycarboxylic acid |
| | 8 g/l Na₂SO₃ |
| | 1.47 g/l K[Au(CN)₂] |
| DI water | Deionized water |

### Wire bonding

After deposition of the metal layer(s) as described in tables 1 and 2, a silver or silver alloy wire was bonded onto the plated wire bonding portions at 165 °C. The wire bonding process was performed using a Kulicke and Soffa Max Ultra wire bonder with a Microenvironment Copper Kit. Forming gas (5%/95% H₂/N₂) protected the free-air ball during the bonding process. The bonding tool was a Kulicke and Soffa CuPRAplus capillary with 1.25 mil chamfer diameter and 60° inner chamfer angle. Bonding was performed with the aid of an ultra-sonic treatment.

The palladium or gold surface was cleaned with a plasma-etching process prior to bonding which is known to those skilled in the art. Alternative cleaning methods such as chemical cleaning may also be used.

### Testing of samples

The layer thickness was measured by x-ray fluorescence on a Fischerscope^{®} x-ray XDV-µ^{®} by Helmut Fischer GmbH. The pull tests were performed on a Dage 4000 by Nordson Corp. Pull tests were conducted at top-of-loop. Since ultrasonic energy is the main factor responsible for both bond formation and pad damage generally the effect of this energy was more closely studied and the so-called ultrasonic power bonding window was determined for each sample. Therefore both, the breaking mode and the pull strength were measured as a function of the ultra-sonic energy during the bonding process. The test results are summarized in the subsequent tables. In the pull tests generally it is distinguished between the break of the wire itself ("wire break"), the breaking of the part of the wire directly next to one of the bonding sites (either "heel break" or "neck break"). These aforementioned breaking modes represent the desired results. If one of the bonding sites itself breaks or the wire is pulled out entirely the mode is called neck or heel lift. The latter cases are highly undesired as they represent a weak bonding of the substrate to the wire. Increasing pull strength values correspond to stronger bonds between the substrate and the wire which is desired. Pull strength values below 2 g are generally considered not to suffice to form a reliable bond between the substrate and the silver wire. Values above 2 g are "acceptable", values exceeding 3 g are considered to be "good", values of more than 4.5 g are defined as "very good".

Samples obtained by the plating processes:

**Table 3: Overview of the samples used**

| **Sample** | **Wire** | **Layer assembly on substrate** |
|---|---|---|
| 1 | Ag-Pd-alloy, 20 µm | 150 nm Pd |
| 2 | Ag-Pd-alloy, 20 µm | 100 nm Pd, 150 nm Au |
| 3 | Ag alloy wire, >88% Ag, 20 µm | 150 nm Pd |
| 4 | Ag wire, >88% Ag, 20 µm | 100 nm Pd, 150 nm Au |
| 5 | Ag-alloy wire, >95% Ag, 20 µm | 100 nm Pd, 150 nm Au |

**Table 4: Pull strength and break modes of sample 1**

| Ultrasonic energy [mAmps] | Number of tested samples | Pull strength [g] | Standard deviation of the pull strength [g] | Break mode | | |
|---|---|---|---|---|---|---|
| | | | | Heel break | Neck break | Heel lift / neck lift |
| 110 | 30 | 4.6 | 0.7 | 29 | 0 | 1 |
| 120 | 30 | 4.8 | 0.6 | 30 | 0 | 0 |
| 130 | 30 | 4.8 | 0.7 | 30 | 0 | 0 |
| 140 | 30 | 4.9 | 0.6 | 30 | 0 | 0 |
| 150 | 30 | 4.3 | 0.4 | 30 | 0 | 0 |
| 160 | 30 | 4.9 | 0.6 | 30 | 0 | 0 |
| 170 | 30 | 4.3 | 0.6 | 30 | 0 | 0 |

The pull strength values of sample 1 (cf. table 4) are at least "good" or in most cases "very good" and the break modes are all but one of the desired types. Therefore, a wide suitable bonding window from 120 to 170 mAmps for the bonding of a silver alloy wire onto the substrate was made available by the inventive process.

**Table 5: Pull strength and break modes of sample 2**

| Ultrasonic energy [mAmps] | Number of tested samples | Pull strength [g] | Standard deviation of the pull strength [g] | Break mode | | |
|---|---|---|---|---|---|---|
| | | | | Heel break | Neck break | Heel lift / neck lift |
| 110 | 30 | 6.0 | 0.7 | 30 | 0 | 0 |
| 120 | 30 | 5.5 | 0.4 | 30 | 0 | 0 |
| 130 | 30 | 5.4 | 0.6 | 30 | 0 | 0 |
| 140 | 30 | 4.5 | 0.6 | 30 | 0 | 0 |
| 150 | 30 | 4.5 | 0.6 | 30 | 0 | 0 |
| 160 | 30 | 5.0 | 0.6 | 30 | 0 | 0 |
| 170 | 30 | 5.3 | 0.5 | 30 | 0 | 0 |
| 180 | 30 | 5.7 | 0.4 | 30 | 0 | 0 |
| 190 | 30 | 5.7 | 0.5 | 30 | 0 | 0 |
| 200 | 30 | 5.1 | 0.5 | 30 | 0 | 0 |

The pull strength values of sample 2 (cf. table 5) are all classified as "very good" and the break modes are all of the desired types. Therefore, a wide suitable bonding window from 110 to 200 mAmps for the bonding of a silver alloy wire onto the substrate was made available by the inventive process.

**Table 6: Pull strength and break modes of sample 3**

| Ultrasonic energy [mAmps] | Number of tested samples | Pull strength [g] | Standard deviation of the pull strength [g] | Break mode | | |
|---|---|---|---|---|---|---|
| | | | | Heel break | Neck break | Heel lift / neck lift |
| 100 | 30 | 8.2 | 0.7 | 21 | 9 | 0 |
| 110 | 30 | 7.8 | 1.0 | 14 | 16 | 0 |
| 120 | 30 | 8.2 | 0.6 | 24 | 6 | 0 |
| 130 | 30 | 7.3 | 1.0 | 7 | 23 | 0 |
| 140 | 30 | 6.8 | 1.2 | 7 | 23 | 0 |
| 150 | 30 | 6.6 | 1.3 | 5 | 25 | 0 |
| 160 | 30 | 6.5 | 1.0 | 3 | 27 | 0 |
| 170 | 30 | 5.8 | 0.9 | 1 | 29 | 0 |
| 180 | 30 | 6.0 | 1.4 | 4 | 26 | 0 |

The pull strength values of sample 3 (cf. table 6) are all in the classification "very good" and the break modes are all of the desired types. Therefore, a wide suitable bonding window from 100 to 180 mAmps for the bonding of a silver alloy wire onto the substrate was made available by the inventive process.

**Table 7: Pull strength and break modes of sample 4**

| Ultrasonic energy [mAmps] | Number of tested samples | Pull strength [g] | Standard deviation of the pull strength [g] | Break mode | | |
|---|---|---|---|---|---|---|
| | | | | Heel break | Neck break | Heel lift / neck lift |
| 100 | 30 | 6.3 | 0.5 | 30 | 0 | 0 |
| 110 | 30 | 6.7 | 0.6 | 30 | 0 | 0 |
| 120 | 30 | 6.6 | 0.5 | 30 | 0 | 0 |
| 130 | 30 | 6.2 | 0.6 | 30 | 0 | 0 |
| 140 | 30 | 6.9 | 0.5 | 29 | 1 | 0 |
| 150 | 30 | 6.2 | 0.9 | 29 | 1 | 0 |
| 160 | 30 | 6.8 | 0.6 | 28 | 0 | 2 |
| 170 | 30 | 7.2 | 0.5 | 30 | 0 | 0 |
| 180 | 30 | 6.4 | 0.6 | 30 | 0 | 0 |
| 190 | 30 | 5.6 | 0.5 | 30 | 0 | 0 |

The pull strength values of sample 4 (cf. table 7) are all in the classification "very good" and the break modes are all of the desired types. Therefore, a wide suitable bonding window from 100 to 190 mAmps for the bonding of the silver alloy wire onto the substrate was made available by the inventive process. It is known to those in the art that the decreasing standard deviation of the pull strength values represents a more stable process. It is therefore apparent from the data in table 7 that the bonding process itself becomes more stable.

**Table 8: Pull strength and break modes of sample 5**

| Ultrasonic energy [mAmps] | Number of tested samples | Pull strength [g] | Standard deviation of the pull strength [g] | Break mode | | |
|---|---|---|---|---|---|---|
| | | | | Heel break | Neck break | Heel lift / neck lift |
| 90 | 30 | 6.4 | 0.9 | 28 | 2 | 0 |
| 100 | 30 | 5.9 | 0.7 | 30 | 0 | 0 |
| 110 | 30 | 6.0 | 0.7 | 30 | 0 | 0 |
| 120 | 30 | 5.6 | 0.8 | 30 | 0 | 0 |
| 130 | 30 | 6.3 | 0.6 | 30 | 0 | 0 |
| 140 | 30 | 6.0 | 1.1 | 30 | 0 | 0 |
| 150 | 30 | 5.2 | 1.0 | 30 | 0 | 0 |

The pull strength values of sample 5 (cf. table 8) are all in the classification "very good" and the break modes are all of the desired types. Therefore, a wide suitable bonding window from 110 to 150 mAmps for the bonding of a silver alloy wire onto the substrate was made available by the inventive process.

The so-called bonding window represents the ultrasonic energies which are feasible to form a robust bonding site, i.e. pull strength values exceeding 2 g. It can be easily seen that all tested samples offer suitable bonding windows of at least 110 to 150 mAmps regardless of the used layer assemblies. When comparing sample 1 and 2 it was found that the optional gold layer was an asset because it enhanced the robustness of the bonding, i.e. by showing higher pull strength values. However, that is not generally the case as the pull strength values of sample 3 and 4 are different and sample 3 showed superior results in that respect. Additionally, it is advantageous not to use a second layer of a costly noble metal if it not strictly needed as resources and process time are being saved. Therefore, it can be summarized that the inventive process allows for robust bonding of the silver based wires - regardless of their actual composition - and the substrate which has been submitted to the process according to the invention.

## Claims

1. A method for forming a silver based wire on a substrate, said substrate having at least one wire bonding portion made of copper or copper alloy comprising the steps of
(i) providing a substrate having at least one wire bonding portion made of copper or copper alloy;
(ii) forming a palladium or palladium alloy layer on the at least one wire bonding portion, wherein the palladium is deposited from a wet chemical plating bath;
(iii) bonding a silver based wire onto the palladium or palladium alloy layer.

2. The method according to claim 1, wherein the palladium or palladium alloy layer according to step (ii) is formed directly upon the copper or copper alloy bonding portion.

3. The method according to any of the foregoing claims further comprising after step (ii)
(ii) a) forming a gold or gold alloy layer on the palladium or palladium alloy layer, wherein the gold or gold alloy layer is deposited from a wet chemical plating bath.

4. The method according to any of the foregoing claims, wherein the wet chemical palladium or palladium alloy plating bath is an electroless (autocatalytic) plating palladium bath comprising
- a palladium ion source;
- a complexing agent;
- a chemical reducing agent.

5. The method according to any of the foregoing claims, wherein the palladium layer is a pure palladium layer having a palladium content of more than 99.9 wt.-%.

6. The method according to any of the foregoing claims, wherein the palladium layer is a palladium alloy having a palladium content of more than 90.0 wt.-% and 0.1 - 10 wt.-% phosphorus and / or boron.

7. The method according to any of the foregoing claims, wherein the palladium or palladium alloy layer has a thickness of 0.01 - 5.0 µm.

8. The method according to any of the foregoing claims, wherein the wet chemical gold or gold alloy plating bath is an immersion plating bath comprising
- a gold ion source;
- a complexing agent,
and the resulting gold or gold alloy layer has a thickness of 0.05 - 3.0 µm.

9. The method according to any of the foregoing claims, wherein the silver based wire is a silver wire or silver alloy wire or coated silver which is coated with a gold, palladium, platinum or rhodium layer or a coated silver alloy wire, which is coated with a gold, palladium, platinum or rhodium layer.

10. The method according to claim 9, wherein the coating has a thickness of 1 - 500 nm.

11. The method according to any of the foregoing claims wherein prior to step (ii) the at least one wire bonding portion is activated by immersing it into a solution containing palladium ions.

12. A layer assembly comprising
(i) at least one wire bonding portion layer made of copper or copper alloy;
and directly deposited thereon
(ii) a palladium or palladium alloy layer having a thickness of 0.01 - 5.0 µm;
(ii) a) optionally, a gold or gold alloy layer having a thickness of 0.05 - 3.0 µm and
(iii) a silver based wire bonded onto the deposited metal layer.

13. The layer assembly according to claim 12 obtainable by a method according to any of the claims 1-11.

14. A printed circuit board possessing a layer assembly according to the claims 12 and 13 and additionally a soldering portion for connecting external parts with the printed circuit board.

15. An integrated circuit possessing a layer assembly according to the claims 12 and 13.
